# EUROPEAN PATENT APPLICATION

(11) **EP 4 615 188 A1**
(43) Date of publication of application: **10.09.2025**
(21) Application number: 25150693.7
(22) Date of filing: 08.01.2025
(51) Int. Cl.: H10B 12/00, H01L 25/065, H10B 80/00, H10D 88/00

(54) **SEMICONDUCTOR MEMORY DEVICE AND METHOD OF FABRICATING THE SAME**

(30) Priority: 06.03.2024 KR 20240032132
(71) Applicant: Samsung Electronics Co., Ltd., Suwon-si, Gyeonggi-do 16677 (KR)
(72) Inventor: KWAK, Chaeseok, 16677 Suwon-si (KR); SONG, Jaejoon, 16677 Suwon-si (KR); SEO, Younghun, 16677 Suwon-si (KR); KIM, Hyeontae, 16677 Suwon-si (KR); PARK, Young Seok, 16677 Suwon-si (KR)
(74) Representative: Marks & Clerk LLP

(57) **Abstract**

Disclosed is a semiconductor memory device including a lower structure and an upper structure on the lower structure. The upper structure includes a first substrate, an upper wiring line on the first substrate, a lower power line in a lower portion of the first substrate, and a first bonding pad between the lower power line and the lower structure. The lower power line and the first bonding pad are electrically connected to each other. The upper structure is electrically connected through the first bonding pad to the lower structure.

## Description

### BACKGROUND

The present inventive concepts relate to a semiconductor memory device, and more particularly, to a semiconductor memory device including vertical channel transistors and a method of fabricating the same.

With the trend of reduction in design rule of semiconductor memory devices, the fabrication technology is being improved to increase integration, operating speed, and yield of the semiconductor memory device. Accordingly, transistors with vertical channels have been suggested to increase their integration, resistance, current driving capability, and other characteristics.

### SUMMARY

Some embodiments of the present inventive concepts provide a semiconductor memory device having improved electrical properties and increased integration.

Embodiments of the present inventive concepts are not limited to those mentioned above, and other embodiments, which have not been mentioned above, will be clearly understood to those skilled in the art from the following description.

According to some embodiments of the present inventive concepts, a semiconductor memory device may comprise: a lower structure; and an upper structure on the lower structure. The upper structure may include: a first substrate; an upper wiring line on the first substrate; a lower power line in a lower portion of the first substrate; and a first bonding pad between the lower power line and the lower structure. The lower power line and the first bonding pad may be electrically connected to each other. The upper structure may be electrically connected through the first bonding pad to the lower structure.

According to some embodiments of the present inventive concepts, a semiconductor memory device may comprise: a lower structure; and an upper structure on the lower structure. The upper structure may include: a first substrate; an upper wiring line on the first substrate; a lower power line in a lower portion of the first substrate; and a first bonding pad between the lower power line and the lower structure. The lower structure may include: a second substrate that includes a cell region; and a second bonding pad on the cell region. The first bonding pad may be exposed through a rear surface of the upper structure. The second bonding pad may be exposed through a front surface of the lower structure. The front surface of the lower structure may be in contact with the rear surface of the upper structure. The first bonding pad and the second bonding pad may directly contact each other.

According to some embodiments of the present inventive concepts, a semiconductor memory device may comprise: a lower structure; an upper structure on the lower structure; and a bonding structure between the lower structure and the upper structure. The upper structure may include: a first substrate; an upper wiring line on the first substrate; a lower power line in a lower portion of the first substrate; and a backside through via that extends through the first substrate and connects the upper wiring line to the lower power line. The lower structure may include: a second substrate that includes a cell region; and a lower wiring layer on the cell region. The bonding structure may include: a first part in a lower portion of the upper structure; and a second part in an upper portion of the lower structure. The bonding structure may electrically connect the lower power line and the lower wiring layer to each other.

At least some of the above and other features of the invention are set out in the claims.

### BRIEF DESCRIPTION OF DRAWINGS

FIG. 1 is a block diagram illustrating a semiconductor memory device according to some embodiments of the present inventive concepts.
FIG. 2 is a simplified perspective view illustrating a semiconductor memory device according to some embodiments of the present inventive concepts.
FIG. 3A is a plan view illustrating a semiconductor memory device according to some embodiments of the present inventive concepts.
FIG. 3B is a plan view illustrating a semiconductor memory device according to some embodiments of the present inventive concepts.
FIG. 4 is a cross-sectional view illustrating a semiconductor memory device according to some embodiments of the present inventive concepts.
FIGS. 5A to 5E and 6A to 6D are cross-sectional diagrams illustrating a method of fabricating a semiconductor memory device according to some embodiments of the present inventive concepts.
FIG. 7 is a cross-sectional view illustrating a semiconductor memory device according to some embodiments of the present inventive concepts.
FIGS. 8A, 8B, 9A, 9B, 10, 11, and 12 are cross sectional diagrams illustrating a method of fabricating a semiconductor memory device according to some embodiments of the present inventive concepts.
FIG. 13 is a cross-sectional view illustrating a semiconductor memory device according to some embodiments of the present inventive concepts.

### DETAILED DESCRIPTION OF EMBODIMENTS

The following will now describe some embodiments of the present inventive concepts with reference to the accompanying drawings. Like reference numerals may indicate like components throughout the description. As used herein, the term "and/or" includes any and all combinations of one or more of the associated listed items. It will be understood that, although the terms "first," "second," "upper portion," "lower portion," etc. may be used herein to describe various elements or components, these elements or components should not be limited by these terms. These terms are only used to distinguish one element or component from another element or component. Therefore, a first element or component discussed below could be termed a second element or component. It is noted that aspects described with respect to one embodiment may be incorporated in different embodiments although not specifically described relative thereto. That is, all embodiments and/or features of any embodiments can be combined in any way and/or combination. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

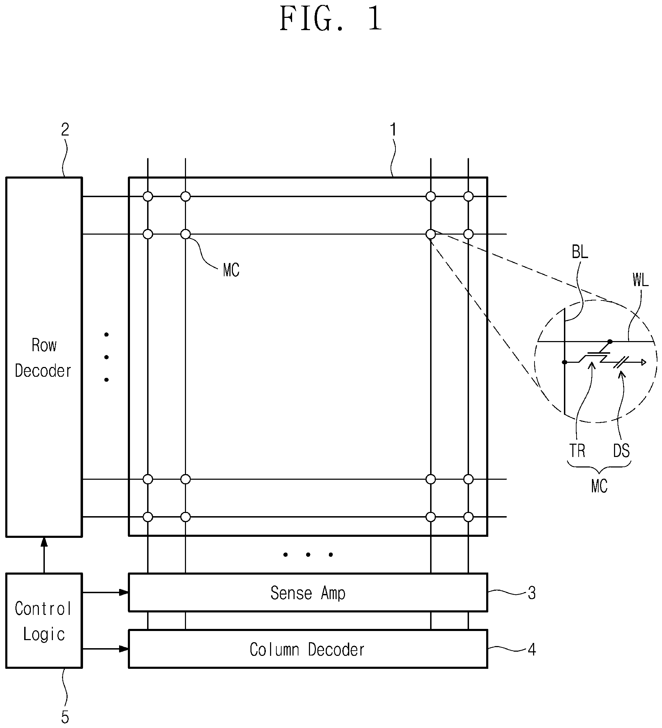

FIG. 1 is a block diagram illustrating a semiconductor memory device according to some embodiments of the present inventive concepts.

Referring to FIG. 1, a semiconductor memory device may include a memory cell array 1, a row decoder 2, a sense amplifier 3, a column decoder 4, and a control logic 5.

The memory cell array 1 may include a plurality of memory cells MC that are arranged two-dimensionally or three-dimensionally. Each of the memory cells MC may be connected between a word line WL and a bit line BL that intersect each other.

Each of the memory cells MC may include a selection element TR and a data storage element DS, and the selection element TR and the data storage element DS may be electrically connected in series to each other. The selection element TR may be connected between the data storage element DS and the word line WL, and the data storage element DS may be connected through the selection element TR to the bit line BL. The selection element TR may be a transistor (e.g. a field effect transistor (FET)), and the data storage element DS may be a capacitor, a magnetic tunnel junction pattern, or a variable resistor. For example, the selection element TR may include a transistor, a gate electrode of the transistor may be connected to the word line WL, and source/drain terminals of the transistor may be connected to the bit line BL and the data storage element DS.

The row decoder 2 may decode an address that is externally input, and may select one of the word lines WL of the memory cell array 1. The address that is decoded in the row decoder 2 may be provided to a row driver (not shown), and in response to a control operation of control circuits, the row driver may provide a certain voltage to a selected word line WL and each of non-selected word lines WL.

In response to an address that is decoded from the column decoder 4, the sense amplifier 3 may detect and amplify a voltage difference between a selected bit line BL and a reference bit line, and may then output the amplified voltage difference.

The column decoder 4 may provide a data delivery pathway between the sense amplifier 3 and an external device (e.g., a memory controller). The column decoder 4 may decode an address that is externally input and may select one of the bit lines BL.

The control logic 5 may generate control signals that control operations to write data to the memory cell array 1 and/or to read data from the memory cell array 1.

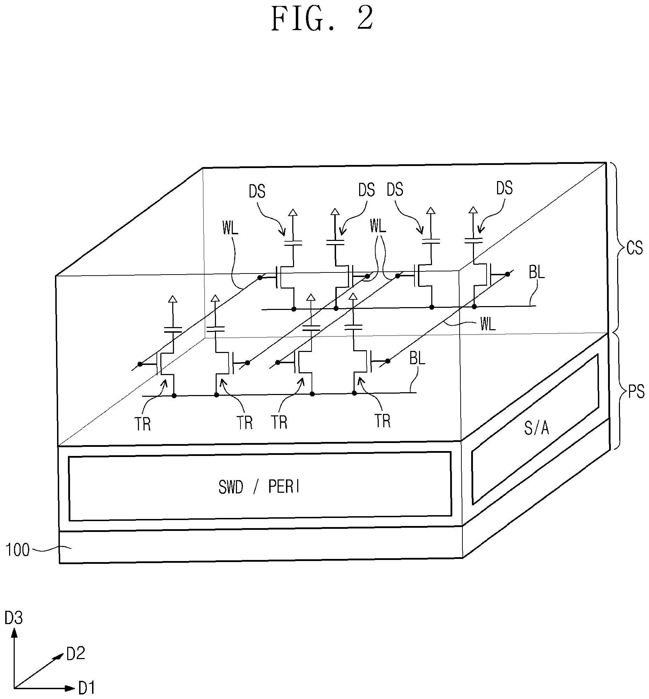

FIG. 2 is a simplified perspective view illustrating a semiconductor memory device according to some embodiments of the present inventive concepts.

Referring to FIG. 2, a semiconductor memory device may include a peripheral circuit structure PS on a semiconductor substrate 100 and may also include a cell array structure CS on the peripheral circuit structure PS. For example, the peripheral circuit structure PS may be positioned between the semiconductor substrate 100 and the cell array structure CS in a third direction D3 perpendicular to a top surface of the semiconductor substrate 100. In this description, the third direction D3 may be called a vertical direction. One or more directions that run parallel to the top surface of the substrate (e.g. a first direction D1 and a second direction D2) may be called horizontal directions. The vertical direction (the third direction D3) may define a height direction of the semiconductor memory device. Components or features that are further along the vertical direction than other components or features may be described as being "above" the other components or features (which may be described as "below"). Similarly, components or features that are further along the vertical direction than other components or features may be described as being "upper" components or features, in comparison to the other components or features which may be described as being "lower" components or features. It will be appreciated that these positional and directional terms are with reference to the structure of the semiconductor memory device. Accordingly, these positional and directional terms do not necessarily limit the orientation of the semiconductor memory device, in use.

The peripheral circuit structure PS may include core/peripheral circuits formed on the semiconductor substrate 100. The core/peripheral circuits may include a row decoder, a column decoder, a sense amplifier, and a control logic that are discussed in FIG. 1.

The cell array structure CS may include bit lines BL, word lines WL, and the memory cells MC of FIG. 1 between the bit lines BL and the word lines WL. The memory cells MC of FIG. 1 may be arranged two-dimensionally or three-dimensionally on a plane defined by a first direction D1 and a second direction D2 that intersect each other (e.g. that are perpendicular to each other). Each of the memory cells MC of FIG. 1 may include a selection element TR and a data storage element DS.

For example, the selection element TR may include a vertical channel transistor (VCT). A channel of the vertical channel transistor may have a shape that extends in a direction (e.g., the third direction D3) perpendicular to the top surface of the semiconductor substrate 100. The data storage element DS may be a capacitor.

The present inventive concepts, however, are not limited thereto. The semiconductor memory device may include the cell array structure CS on the semiconductor substrate 100, and may also include the peripheral circuit structure PS on the cell array structure CS. For example, the cell array structure CS may be positioned between the semiconductor substrate 100 and the peripheral circuit structure PS.

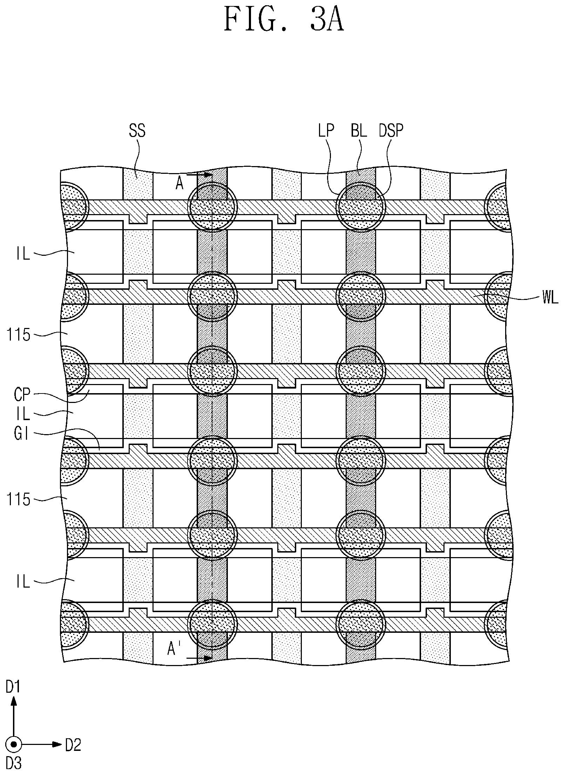

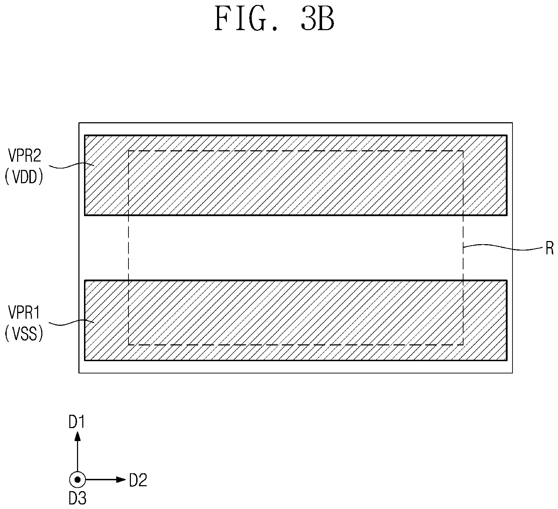

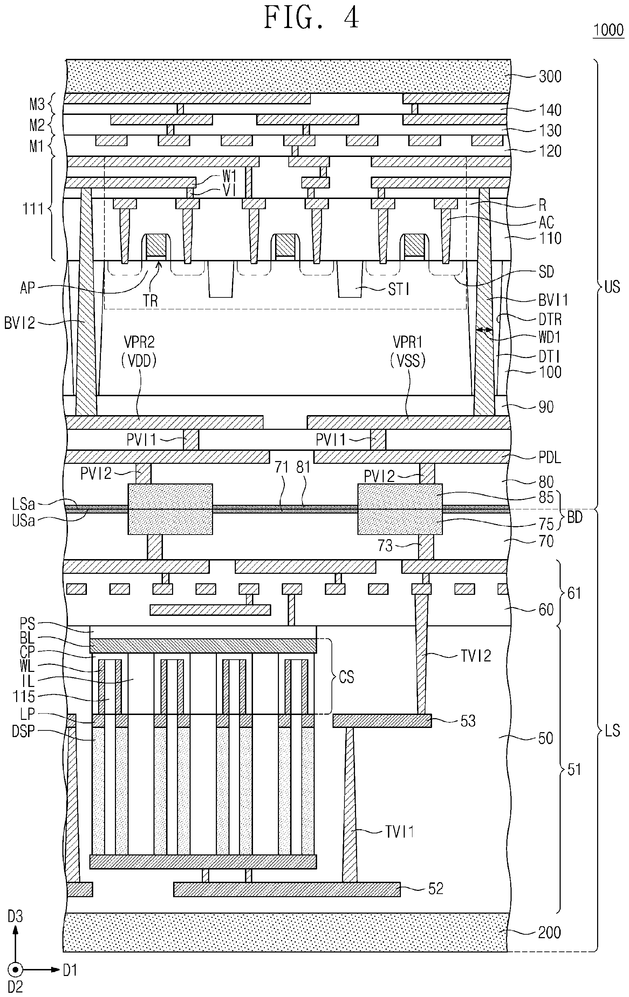

FIGS. 3A and 3B are plan views illustrating a semiconductor memory device according to some embodiments of the present inventive concepts. FIG. 3A shows a plan view of a lower structure LS of the semiconductor memory device, and FIG. 3B shows a plan view of an upper structure US of the semiconductor memory device. FIG. 4 is a cross-sectional view illustrating a semiconductor memory device according to some embodiments of the present inventive concepts.

Referring to FIGS. 3A, 3B, and 4, a semiconductor memory device 1000 may include a lower structure LS and an upper structure US. The upper structure US may be provided on the lower structure LS. A rear surface USa of the upper structure US may be in contact with a front surface LSa of the lower structure LS. In the present application, the vertical direction (the third direction, D3) is described as running in a direction parallel to a direction from a second substrate 200 of the lower structure LS to a first substrate 100 of the upper structure US.

The upper structure US will be further discussed in detail with reference to FIGS. 3B and 4.

The upper structure US may include a semiconductor substrate 100 (referred to hereinafter as a first substrate). The first substrate 100 may be a silicon substrate, but the present inventive concepts are not limited thereto. A cell region and a peripheral region may be provided on the first substrate 100. For example, the first substrate 100 may be provided thereon with a peripheral region R including transistors TR. The peripheral region R may be an area from which signals are provided through the transistors to the cell region.

An active pattern AP may be positioned on the first substrate 100. The active pattern AP may be defined by an isolation pattern STI. The isolation pattern STI may include a dielectric material. The transistors TR and source/drain patterns SD may be provided on the active pattern AP. The source/drain patterns SD may be correspondingly provided on opposite sides of each transistor TR. The source/drain patterns SD may be provided in an upper portion of the active pattern AP. Each source/drain pattern SD may be a source or a drain. One or more transistors TR may be provided, each having a source and a drain located on opposite sides of a corresponding active pattern AP.

The first substrate 100 may include a deep device isolation pattern DTI that vertically (i.e., D3 direction) penetrates or extends through the first substrate 100. The deep device isolation pattern DTI may define the cell region or the peripheral region R. A width in a first direction D1 of the deep device isolation pattern DTI may decrease with increasing distance in a vertical direction D3 from a top surface of the first substrate 100 as shown in FIG. 4.

The deep device isolation pattern DTI may penetrate the first substrate 100. A top surface of the deep device isolation pattern DTI may be coplanar with a top surface of the first substrate 100. A bottom surface of the deep device isolation pattern DTI may be coplanar with a bottom surface of the first substrate 100. The deep device isolation pattern DTI may include a dielectric material.

A first interlayer dielectric layer 110 may be provided on the first substrate 100. An upper wiring layer 111 may be provided in the first interlayer dielectric layer 110. The upper wiring layer 111 may include active contacts AC, an upper wiring line W1, and an upper via VI. The active contact AC may be electrically connected to the source/drain pattern SD. Each source/drain pattern SD may be connected to an active contact AC. The active contact AC may electrically connect the source/drain pattern SD and the upper wiring line W1 to each other. The active contacts AC, the upper wiring line W1, and the upper via VI may each include a metallic material.

A second interlayer dielectric layer 120, a third interlayer dielectric layer 130, and a fourth interlayer dielectric layer 140 may be sequentially provided on the upper wiring layer 111. For example, the first, second, third, and fourth interlayer dielectric layers 110, 120, 130, and 140 may include a silicon oxide layer. For another example, one or more of the second, third, and fourth interlayer dielectric layers 120, 130, and 140 may be omitted. For another example, at least one interlayer dielectric layer may be formed on the fourth interlayer dielectric layer 140.

A first metal layer M1 may be provided in the second interlayer dielectric layer 120. The first metal layer M1 may include first wiring lines. According to some embodiments of the present inventive concepts, a lower substrate 80 may have therein a power line, in the form of power lines VPR1 and VPR2, which is provided to supply a power to the semiconductor memory device 1000. Therefore, a power line may be omitted in the first metal layer M1. The first metal layer M1 may be electrically connected to the active contact AC and the upper wiring line W1.

A second metal layer M2 may be provided in the third interlayer dielectric layer 130. The second metal layer M2 may include second wiring lines. The second wiring lines may be electrically connected to the first wiring lines of the first metal layer M1.

A third metal layer M3 may be provided in the fourth interlayer dielectric layer 140. The third metal layer M3 may include third wiring lines. The third wiring lines may be electrically connected to the second wiring lines of the second metal layer M2.

A first support substrate 300 may be formed on the fourth interlayer dielectric layer 140. The first support substrate 300 may be a silicon substrate, but embodiments of the present inventive concepts are not limited thereto.

A first lower dielectric layer 90 may be provided beneath the first substrate 100. A lower substrate 80 may be provided beneath the first lower dielectric layer 90. In other embodiments, the first lower dielectric layer 90 may be omitted. Dissimilarly, at least one lower interlayer dielectric layer may be formed between the first lower dielectric layer 90 and the lower substrate 80.

The lower substrate 80 may be provided therein with first and second lower power lines VPR1 and VPR2. The first and second lower power lines VPR1 and VPR2 may extend in parallel in a second direction D2 (see FIG. 3B). The peripheral region R may be positioned between the first lower power line VPR1 and the second lower power line VPR2. The first and second lower power lines VPR1 and VPR2 may include at least one material selected from copper, molybdenum, tungsten, and ruthenium.

A power delivery network layer PDL may be provided in the lower substrate 80. The power delivery network layer PDL may be provided beneath (with respect to the vertical direction D3) the first and second lower power lines VPR1 and VPR2. The power delivery network layer PDL may include a plurality of lower wiring lines electrically connected to the first and second lower power lines VPR1 and VPR2.

A first lower power via PVI1 may be provided between the power delivery network layer PDL and the first and second lower power lines VPR1 and VPR2. The first lower power via PVI1 may electrically connect the power delivery network layer PDL to the first and second lower power lines VPR1 and VPR2.

The power delivery network layer PDL may be configured to apply a voltage to the first and second lower power lines VPR1 and VPR2. For example, the power delivery network layer PDL may be configured to provide the first and second lower power lines VPR1 and VPR2 with at least one voltage selected from VSS, VDD, VBB, VBL, VEQ, VREFA, VINTY, VREFBB, VPP_DIV, VBB1_DIV, VTG_MON1, VREFY, VLANG, VINTA, VREF, VREFPP, VREFLANG, VREFLP, and VPP.

For example, the power delivery network layer PDL may include a wiring network for applying a source voltage VSS to the first lower power line VPR1. The power delivery network layer PDL may include a wiring network for applying a drain voltage VDD to the second lower power line VPR2. The source voltage VSS may be for a source of the transistor TR (e.g. a source of the source/drain pattern SD). The drain voltage VDD may be for a drain of the transistor TR (e.g. a drain of the source/drain pattern SD). Accordingly, the first power line VPR1 may be connected to one or more sources of one or more transistors TR, and the second power line VPR2 may be connected to one or more drains of the one or more transistors TR.

The upper structure US may include a backside through via BVI that vertically (i.e., in the D3 direction) penetrates or extends through the deep device isolation pattern DTI. The backside through via BVI may vertically (i.e., in the D3 direction) and electrically connect the upper wiring layer 111 on the first substrate 100 to the first and second lower power lines VPR1 and VPR2. For example, a first backside through via BVI1 may vertically (i.e., in the D3 direction) and electrically connect the upper wiring line W1 of the upper wiring layer 111 to the first lower power line VPR1. A second backside through via BVI2 may vertically (i.e., in the D3 direction) and electrically connect the upper wiring line W1 of the upper wiring layer 111 to the second lower power line VPR2. The first and second backside through vias BVI1 and BVI2 may each be electrically connected through the upper wiring line W1 to the active contacts AC (e.g. to one or more respective active contacts AC). For instance, the first backside through via BVI1 may be connected to a first set of active contacts AC that are connected to a first set of source/drain regions (e.g. source/drain regions located on one side of the transistors TR, such as drain regions). Similarly, the second backside through via BVI2 may be connected to a second set of active contacts AC that are connected to a second set of source/drain regions (e.g. source/drain regions located on another side of the transistors TR, such as source regions).

The first and second backside through vias BVI1 and BVI2 may each have a first width WD1 in the first direction D1. The first width WD1 may decrease with increasing distance in the vertical direction D3 from top surfaces of the first and second lower power lines VPR1 and VPR2. The first and second backside through vias BVI1 and BVI2 may include a metallic material.

The lower structure LS will be further discussed in detail with reference to FIGS. 3A and 4.

The lower structure LS may include a second substrate 200. The second substrate 200 may be a silicon substrate, but the present inventive concepts are not limited thereto.

A first lower interlayer dielectric layer 50 may be provided on the second substrate 200. The first lower interlayer dielectric layer 50 may include a dielectric material. For example, the first lower interlayer dielectric layer 50 may include a plurality of dielectric layers.

A memory cell region 51 may be provided in the first lower interlayer dielectric layer 50. For example, a vertical channel transistor DRAM may be provided on the second substrate 200, but the present inventive concepts are not limited thereto. The memory cell region 51 of FIG. 4 may correspond to a cross-sectional view taken along line A-A' of FIG. 3A.

The second substrate 200 may be provided thereon with a peripheral circuit structure PS and a cell array structure CS on the peripheral circuit structure PS. The peripheral circuit structure PS may include core circuits, a lower dielectric layer that covers the core circuits, lower contact plugs, and circuit lines. The peripheral circuit structure PS is shown in simplified form in the figures for improved clarity, therefore not all components of the peripheral circuit structure PS may be shown.

The core circuits may include NMOS and PMOS transistors. The core circuits may be electrically connected through the circuit lines to bit lines BL and word lines WL, which will be discussed below.

The cell array structure CS may include bit lines BL, channel patterns CP, word lines WL, mold dielectric patterns IL, landing pads LP, and data storage patterns DSP.

On the second substrate 200, the bit lines BL may extend in the first direction D 1 and may be spaced apart from each other in the second direction D2. For example, the bit lines BL may include doped polysilicon, metal, conductive metal nitride, conductive metal silicide, conductive metal oxide, or any combination thereof. The bit lines BL may each be formed of a single layer or multiple layers. The bit lines BL may include a carbon-based two-dimensional material such as graphene, a carbon-based three-dimensional material such as carbon nano-tube, or any combination thereof.

The mold dielectric patterns IL may be provided on the bit lines BL. Each of the mold dielectric patterns IL may extend in the second direction D2, while running across the bit lines BL. The mold dielectric patterns IL may include, for example, one or more of silicon oxide, silicon nitride, silicon oxynitride, and low-k dielectrics. A low-k dielectric (a low-k dielectric material) may be a material that has a dielectric constant that is lower than that of silicon oxide.

The channel patterns CP may be positioned on the bit lines BL. The channel patterns CP may be spaced apart from each other in the second direction D2 between the mold dielectric patterns IL. Each of the channel patterns CP may have a U-shaped cross-section. A width in the second direction D2 of each of the channel patterns CP may be greater than a width in the second direction D2 of each of the bit lines BL.

The channel patterns CP may include, for example, an oxide semiconductor. The oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or any combination thereof. In other embodiments, the channel patterns CP may include indium-gallium-zinc oxide (IGZO). The channel patterns CP may each be formed of a single layer including one oxide semiconductor or a multiple layer including different oxide semiconductors. The channel patterns CP may include an amorphous, crystalline, or polycrystalline oxide semiconductor. The channel patterns CP may each have bandgap energy greater than that of silicon. For example, the channel patterns CP may each have bandgap energy of about 1.5 eV to about 5.6 eV (e.g. of 1.5 eV to 5.6 eV), and may exhibit desired channel performance when the bandgap energy is in a range of about 2.0 eV to about 4.0 eV (e.g. 2.0 eV to 4.0 eV).

The word lines WL may be positioned on the channel patterns CP. The word lines WL may extend in the second direction D2, while running across the bit lines BL and the channel patterns CP.

For example, the word lines WL may include doped polysilicon, metal, conductive metal nitride, conductive metal silicide, conductive metal oxide, or any combination thereof. The word lines WL may each be formed of a single layer or a multiple layer including different materials. The word lines WL may include a carbon-based two-dimensional material, such as graphene, a carbon-based three-dimensional material such as carbon nano-tube, or any combination thereof.

A first dielectric pattern 115 may be provided between a pair of word lines WL. Each of the first dielectric patterns 115 may be positioned between a corresponding pair of word lines WL. Each of the first dielectric patterns 115 may extend along the second direction D2. The first dielectric patterns 115 may be spaced apart from each other in the first direction D1. The first dielectric patterns 115 and the mold dielectric patterns IL may be alternately arranged along the first direction D1.

Landing pads LP may be positioned on corresponding word lines WL. The landing pads LP may be in contact with the channel patterns CP and the mold dielectric patterns IL. Each of the landing pads LP may have a circular shape when viewed in plan, but the present inventive concepts are not limited thereto. For example, each of the landing pads LP may have an oval shape, a rectangular shape, a square shape, a rhombic shape, a hexagonal shape, or any other suitable shapes when viewed in plan. The landing pads LP may be spaced apart from each other in the first direction D1 and the second direction D2. The landing pads LP may include, for example, doped polysilicon, metal, conductive metal nitride, conductive metal silicide, conductive metal oxide, or any combination thereof.

The data storage patterns DSP may be positioned on the landing pads LP. The data storage patterns DSP may be electrically connected through the landing pads LP to the channel patterns CP. When viewed in plan, each of the data storage patterns DSP may overlap a corresponding one of the landing pads LP. For example, the data storage patterns DSP may be spaced apart from each other in the first direction D1 and the second direction D2.

For example, the data storage patterns DSP may each be a capacitor. In this case, the data storage patterns DSP may include a bottom electrode, a top electrode, and a dielectric layer between the bottom electrode and the top electrode. The bottom electrode may be in contact with the landing pad LP. In other embodiments, the data storage patterns DSP may each be a variable resistance pattern whose two resistance states can be switched due to an electrical pulse applied to a memory element. In this case, the data storage patterns DSP may include a phase-change material whose crystalline state is changed based on an amount of current, perovskite compounds, transition metal oxide, magnetic materials, ferromagnetic materials, or antiferromagnetic materials. The data storage patterns DSP are shown in simplified form in the figures for clarity, therefore not all components of the data storage patterns DSP may be shown.

A plurality of wiring lines may be provided in the first lower interlayer dielectric layer 50. For example, a first connection line 52 and a second connection line 53 may be provided in the first lower interlayer dielectric layer 50. The first connection line 52 may be provided beneath (i.e., with respect to the D3 direction) and electrically connected to the data storage pattern DSP. The second connection line 53 may be provided on the first connection line 52 and may be electrically connected to the first connection line 52 through a first through via TVI1. The second connection line 53 may be electrically connected through a second through via TVI2 to a lower wiring layer 61 which will be discussed below. In other embodiments, the connection lines 52 and 53 and the through vias TVI1 and TVI2 may be variously disposed. Dissimilarly, at least one wiring line may be additionally provided in the first lower interlayer dielectric layer 50.

A second lower interlayer dielectric layer 60 may be formed on the memory cell region 51. A lower wiring layer 61 may be formed in the second lower interlayer dielectric layer 60. The lower wiring layer 61 may include a plurality of wiring lines. The data storage patterns DSP may be electrically connected to the lower wiring layer 61 through wiring lines in the first lower interlayer dielectric layer 50. For example, the data storage patterns DSP may be electrically connected to the lower wiring layer 61 through the first connection line 52, the first through via TVI1, the second connection line 53, and the second through via TVI2.

A third lower interlayer dielectric layer 70 may be provided on the second lower interlayer dielectric layer 60. The third lower interlayer dielectric layer 70 may include a dielectric material.

A bonding structure BD may be provided between the lower structure LS and the upper structure US. The bonding structure BD may be provided on a boundary between the lower structure LS and the upper structure US. A top surface of the bonding structure BD may be located at a higher level (i.e., in the D3 direction) than that of the rear surface USa of the upper structure US. A bottom surface of the bonding structure BD may be located at a higher level (i.e., with respect to the D3 direction) than that of the front surface LSa of the lower structure LS.

The bonding structure BD may include one or more first bonding pads 85 and one or more second bonding pads 75. Each first bonding pad 85 may be connected to a corresponding second bonding pad 75. Each first bonding pad 85 may be buried in a lower portion of the upper structure US. For example, the first bonding pad 85 may be buried in the lower substrate 80. Each second bonding pad 75 may be buried in an upper portion of the lower structure LS. For example, the second bonding pad 75 may be buried in the third lower interlayer dielectric layer 70 of the lower structure LS. The first bonding pad 85 may be exposed through the rear surface USa of the upper structure US. The second bonding pad 75 may be exposed through the front surface LSa of the lower structure LS.

The first bonding pad 85 and the second bonding pad 75 may include the same material. The first bonding pad 85 and the second bonding pad 75 may include a metallic material. For example, the first bonding pad 85 and the second bonding pad 75 may include copper (Cu). The first bonding pad 85 and the second bonding pad 75 may directly contact each other. The first bonding pad 85 and the second bonding pad 75 may be integrally bonded into a single unitary or monolithic piece. No interface may be present between the first bonding pad 85 and the second bonding pad 75.

The first bonding pad 85 may be electrically connected to the power delivery network layer PDL and the lower power lines VPR1 and VPR2. For example, the first bonding pad 85 may be vertically (i.e., D3 direction) and electrically connected to the power delivery network layer PDL through a second lower power via PVI2. In this configuration, the first bonding pad 85 may be electrically connected to the lower power lines VPR1 and VPR2 through a first lower power via PVI1, the power delivery network layer PDL, and the second lower power via PVI2.

The second bonding pad 75 may be electrically connected to the lower wiring layer 61. For example, the second bonding pad 75 may be electrically connected through a lower via 73 to wiring lines of the lower wiring layer 61. In this configuration, the second bonding pad 75 may be electrically connected to the data storage patterns DSP through the lower wiring layer 61 and the connection lines 52 and 53 in the first lower interlayer dielectric layer 50 (e.g. and through the first and second through vias TVI1 and TVI2).

The bonding structure BD may electrically connect the upper structure US and the lower structure LS to each other. For example, the bonding structure BD may electrically connect the lower power lines VPR1 and VPR2 to the lower wiring layer 61. The upper structure US may be electrically connected to the lower structure LS through the first and second bonding pads 85 and 75.

Nitride patterns 71 and 81 may be provided on the boundary between the upper structure US and the lower structure LS. A first nitride pattern 81 may be provided on the rear surface USa of the upper structure US. For example, the first nitride pattern 81 may be provided on a bottom surface of the lower substrate 80. A second nitride pattern 71 may be provided on the front surface LSa of the lower structure LS. For example, the second nitride pattern 71 may be provided on a top surface of the third lower interlayer dielectric layer 70.

The first nitride pattern 81 may extend in the first direction D1 along the bottom surface of the lower substrate 80. The second nitride pattern 71 may extend in the first direction D1 along the top surface of the third lower interlayer dielectric layer 70. The first and second nitride patterns 81 and 71 may vertically (i.e., D3 direction) overlap each other. The first and second nitride patterns 81 and 71 may bond the upper structure US and the lower structure LS to each other.

The first and second nitride patterns 81 and 71 may include nitride. For example, the first and second nitride patterns 81 and 71 may include silicon nitride (SiN). The first and second nitride patterns 81 and 71 may be disposed on one side of the bonding structure BD. A thickness of each of the first and second nitride patterns 81 and 71 may be less than that of the bonding structure BD.

According to some embodiments of the present inventive concepts, the upper structure US and the lower structure LS may be bonded to each other. A hybrid bonding manner may be employed to bond the upper structure US and the lower structure LS to each other. The term "hybrid bonding" may denote that two components including the same material are merged at an interface therebetween. As the first bonding pad 85 and the second bonding pad 75 are bonded into a single unitary piece, the upper structure US and the lower structure LS may be stably bonded to each other.

In addition, as power lines of the upper structure US are buried in a lower portion of the first substrate 100, there may be a reduction in resistance occurring between wiring lines of the upper structure US. The lower power lines VPR1 and VPR2 of the upper structure US may be electrically connected to the bonding structure BD. Thus, the upper structure US and the lower structure LS are stably combined through the bonding structure BD, and simultaneously, the bonding structure BD and power lines may be electrically connected to reduce resistance and to increase the degree of wiring freedom. In conclusion, the semiconductor memory device may have improved electrical properties.

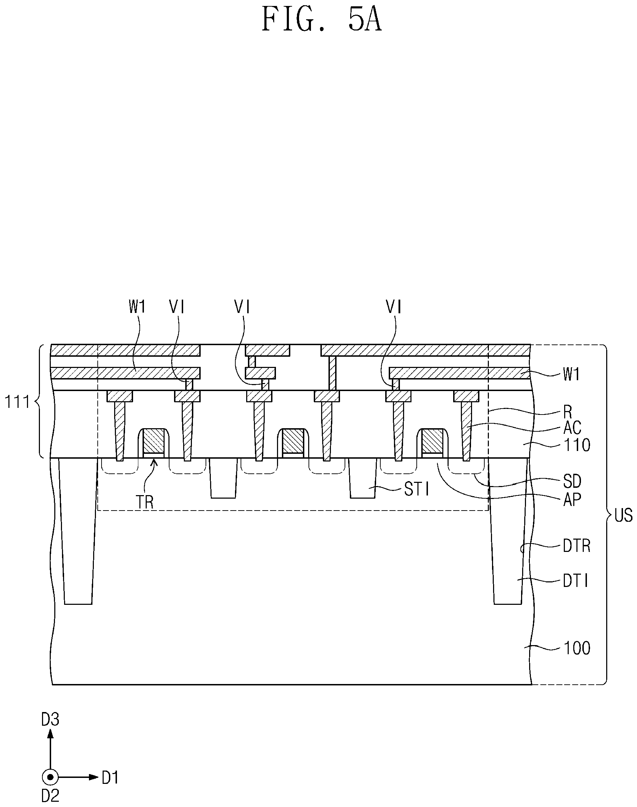

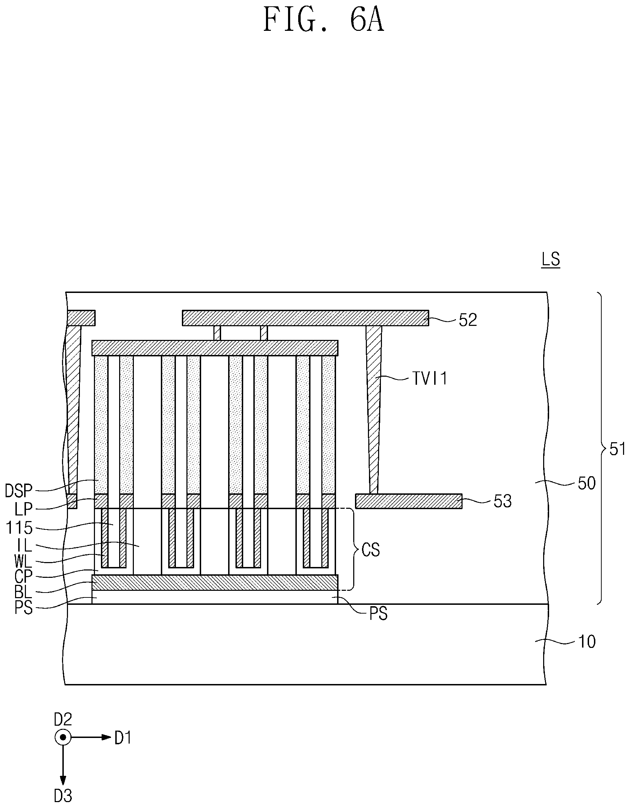

FIGS. 5A to 5E and 6A to 6D are diagrams illustrating a method of fabricating a semiconductor memory device according to some embodiments of the present inventive concepts. FIGS. 5A to 5E are cross-sectional diagrams illustrating a method of manufacturing an upper structure US according to some embodiments of the present inventive concepts. FIGS. 6A to 6D are cross-sectional diagrams illustrating a method of manufacturing a lower structure LS according to some embodiments of the present inventive concepts.

Referring to FIG. 5A, a peripheral region R may be formed on a first substrate 100. In other embodiments, a cell region may be formed on the first substrate 100. A deep device isolation pattern DTI may be formed on the first substrate 100. The formation of the deep device isolation pattern DTI may include forming a hardmask pattern on the first substrate 100, using the hardmask pattern as a mask to etch the first substrate 100 to form a deep device trench DTR, and at least partially filling the deep device trench DTR with a dielectric material.

An isolation pattern STI may be formed on the first substrate 100. A maximum vertical (i.e., D3 direction) depth of the isolation pattern STI may be less than that of the deep device isolation pattern DTI. The formation of the isolation pattern STI may include forming a hardmask pattern on the first substrate 100, using the hardmask pattern as a mask to an upper portion of the first substrate 100 to form a trench, and at least partially filling the trench with a dielectric material.

The isolation pattern STI may define an active pattern AP. One or more transistors TR and source/drain patterns SD may be formed on the active pattern AP. A transistor TR may correspond to a selection element TR of FIG. 1. The source/drain patterns SD may be formed on opposite sides of the transistor TR. The formation of the source/drain pattern SD may include implanting impurities into an upper portion of the active pattern AP.

A first interlayer dielectric layer 110 may be formed on the first substrate 100. An upper wiring layer 111 may be formed in the first interlayer dielectric layer 110. The upper wiring layer 111 may include active contacts AC, upper wiring lines W1, and upper vias VI. Each of the active contacts AC may be vertically (i.e., D3 direction) and electrically connected to a corresponding source/drain pattern SD. The upper vias VI may be provided beneath the upper wiring lines W1. The upper wiring lines W1 may be connected through the upper vias VI to the active contacts AC.

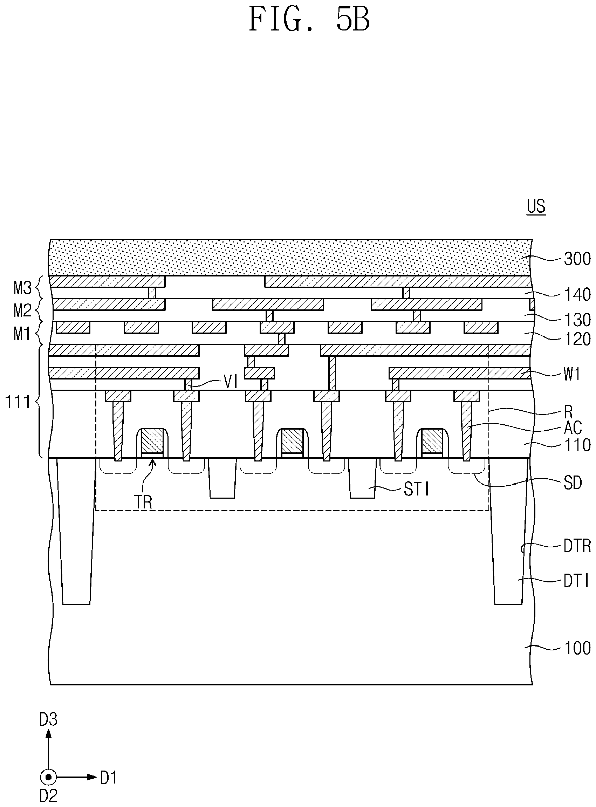

Referring to FIG. 5B, a second interlayer dielectric layer 120 may be formed on the first interlayer dielectric layer 110. The second interlayer dielectric layer 120 may include a silicon oxide layer. A first metal layer M1 may be formed in the second interlayer dielectric layer 120. The first metal layer M1 may be electrically connected to at least one of the active contacts AC and the upper wiring lines W1.

A third interlayer dielectric layer 130 may be formed on the second interlayer dielectric layer 120. A second metal layer M2 may be formed in the third interlayer dielectric layer 130. A fourth interlayer dielectric layer 140 may be formed on the third interlayer dielectric layer 130. A third metal layer M3 may be formed in the fourth interlayer dielectric layer 140. A first support substrate 300 may be formed on the fourth interlayer dielectric layer 140. The first support substrate 300 may be a silicon substrate, but the present inventive concepts are not limited thereto.

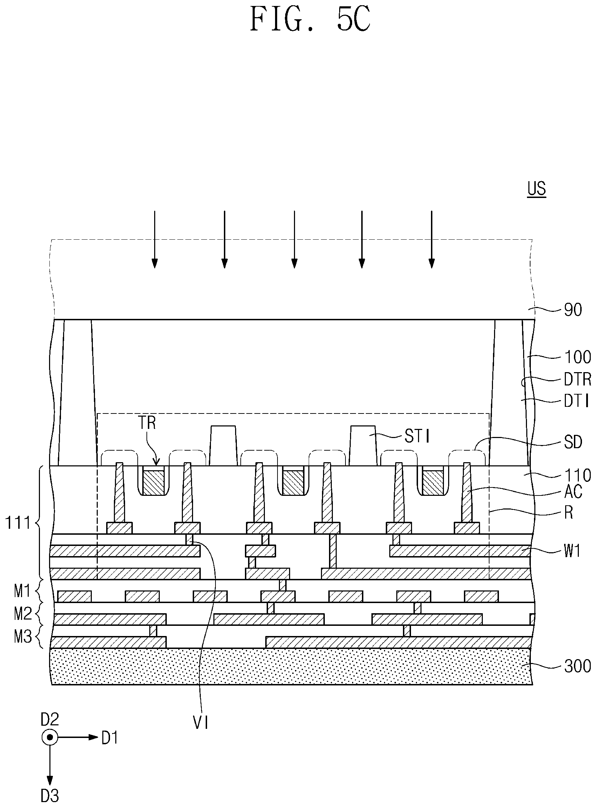

Referring to FIG. 5C, after a back-end-of-line (BEOL) process (e.g. the steps of FIGS. 5A-5B) is completed, the first substrate 100 may be overturned (e.g. inverted) to expose a bottom surface of the first substrate 100. A silicon grinding process and/or a chemical mechanical polishing (CMP) process may be employed to reduce a thickness of the first substrate 100. For example, a thickness of the first substrate 100 depicted in FIG. 5B may be less than that of the first substrate 100 depicted in FIG. 5C. The reduction in thickness of the first substrate 100 may at least partially expose a bottom surface of the deep device isolation pattern DTI. The reduction in thickness of the first substrate 100 may remove a portion of the deep device isolation pattern DTI.

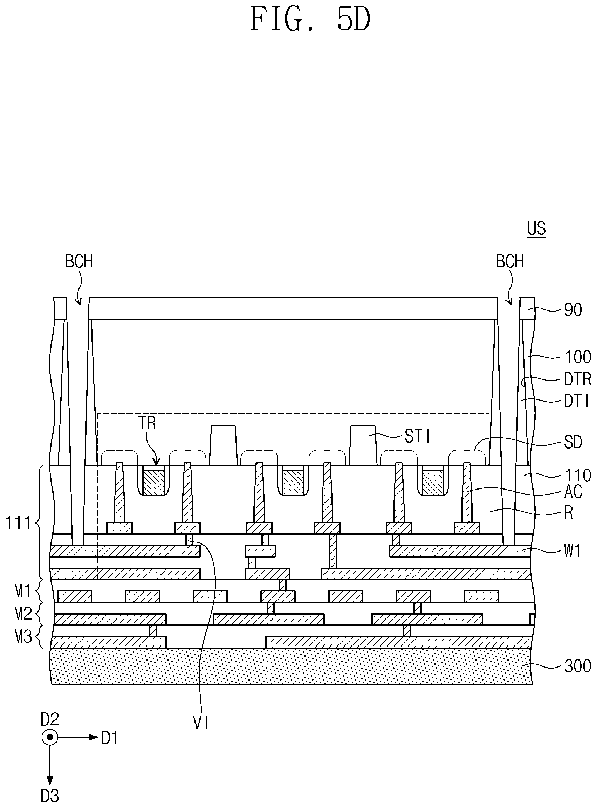

Referring to FIG. 5D, a first lower dielectric layer 90 may be formed on the bottom surface of the first substrate 100. A backside contact hole BCH may be formed in the first lower dielectric layer 90, the first substrate 100, and the first interlayer dielectric layer 110. The backside contact hole BCH may penetrate or extend through the first lower dielectric layer 90 and the deep device isolation pattern DTI. The backside contact hole BCH may at least partially expose the upper wiring line W1 in the first interlayer dielectric layer 110. A width in a first direction D1 of the backside contact hole BCH may increase with increasing distance in a vertical (i.e., D3 direction) direction D3 from an exposed top surface of the upper wiring line W1.

The formation of the backside contact hole BCH may include, for example, forming a mask pattern on the first lower dielectric layer 90, using the mask pattern as a mask to etch the first lower dielectric layer 90, the deep device isolation pattern DTI, and the first interlayer dielectric layer 110.

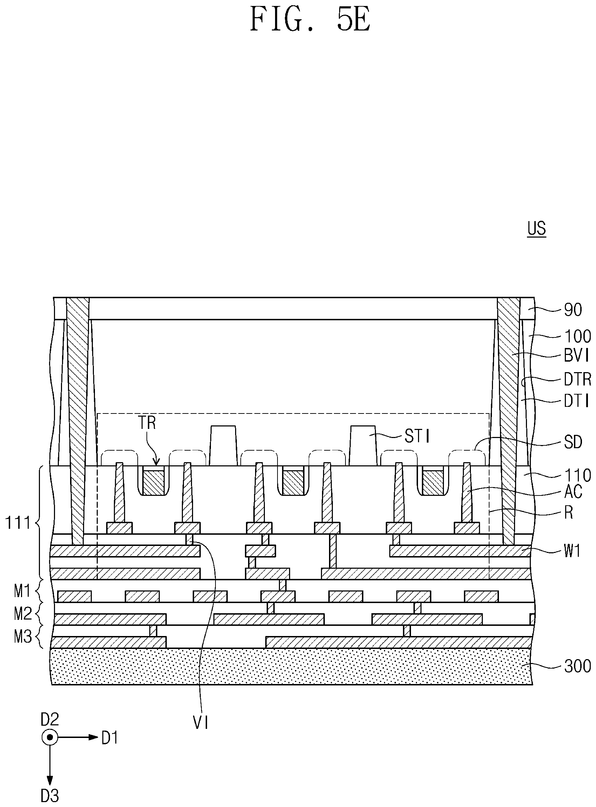

Referring to FIG. 5E, the backside contact hole BCH may be at least partially filled with a metallic material to form a backside through via BVI. For example, the backside through via BVI may include at least one metallic material selected from aluminum, copper, tungsten, molybdenum, ruthenium, and cobalt.

Referring to FIG. 4, a lower substrate 80 may be formed on the first lower dielectric layer 90. The lower substrate 80 may include a dielectric material. First and second lower power lines VPR1 and VPR2 may be formed in the lower substrate 80. The first and second lower power lines VPR1 and VPR2 may be connected to the backside through via BVI.

A first lower power via PVI1 and a power delivery network layer PDL may be formed on the first and second lower power lines VPR1 and VPR2. The power delivery network layer PDL may be configured to apply a voltage to the first and second lower power lines VPR1 and VPR2. For example, the power delivery network layer PDL may apply a source voltage VSS or a drain voltage VDD to the first and second lower power lines VPR1 and VPR2.

A first nitride pattern 81, a second lower power via PVI2, and a first bonding pad 85 may be sequentially formed in the lower substrate 80. The formation of the first nitride pattern 81 may include conformally forming a nitride layer on a top surface of the lower substrate 80, and performing a chemical mechanical polishing (CMP) process to reduce a thickness of the nitride layer.

The formation of the first bonding pad 85 may include forming a mask pattern on the top surface of the lower substrate 80, using the mask pattern as a mask to etch an upper portion of the lower substrate 80, and at least partially filling the etched upper portion of the lower substrate 80 with a metallic material (e.g., copper (Cu)).

Referring to FIG. 6A, a peripheral circuit structure PS including core circuits may be formed on a first preliminary substrate 10.

Bit lines BL may be formed on the peripheral circuit structure PS. Mold dielectric patterns IL may be formed on the bit lines BL. The mold dielectric patterns IL may extend in a second direction D2 and may be spaced apart from each other in the first direction D1. The mold dielectric patterns IL may at least partially expose portions of the bit lines BL. The mold dielectric patterns IL may include, for example, one or more of silicon oxide, silicon nitride, silicon oxynitride, and low-k dielectrics.

A channel layer may be formed to at least partially cover the mold dielectric patterns IL. The channel layer may be formed to have a uniform thickness. The channel layers may be in contact with portions of the bit lines BL. The channel layer may be formed by using at least one process selected from physical vapor deposition (PVD), thermal chemical deposition process (thermal CVD), low pressure chemical vapor deposition (LPCVD), plasma enhanced chemical vapor deposition (PECVD), and atomic layer deposition (ALD). For example, the channel layer may include a semiconductor material, an oxide semiconductor material, or a two-dimensional semiconductor material, or may include silicon, germanium, silicon-germanium, or indium gallium zinc oxide (IGZO).

An etching process may be performed on the channel layer. A portion of the channel layer may be removed such that the channel layer may be formed into channel patterns CP. After the formation of the channel patterns CP, word lines WL may be formed on the channel patterns CP. The word lines WL may have their top surfaces lower (i.e., lower in the D3 direction) than those of the channel patterns CP.

Afterwards, first dielectric patterns 115 may be formed between a pair of word lines WL positioned on one channel pattern CP. Each of the first dielectric patterns 115 may at least partially fill between a pair of word lines WL.

Landing pads LP may be formed on the channel pattern CP and the word line WL. The landing pads LP may be spaced apart from each other in the first direction D1 and the second direction D2. Data storage patterns DSP may be correspondingly formed on the landing pads LP. When the data storage patterns DSP include capacitors, bottom electrodes, a capacitor dielectric layer, and a top electrode may be sequentially formed. The bottom electrodes may be electrically connected to corresponding landing pads LP.

A first lower interlayer dielectric layer 50 may be formed on the first preliminary substrate 10. A plurality of wiring lines may be formed in the first lower interlayer dielectric layer 50. For example, there may be formed wiring lines electrically connected to the data storage pattern DSP. For example, a first connection line 52, a second connection line 53, and a first through via TVI1 may be formed on the first preliminary substrate 10. A photoresist process may be employed to form the first connection line 52, the second connection line 53, and the first through via TVI1. For another example, a plurality of wiring lines may be variously formed in the first lower interlayer dielectric layer 50.

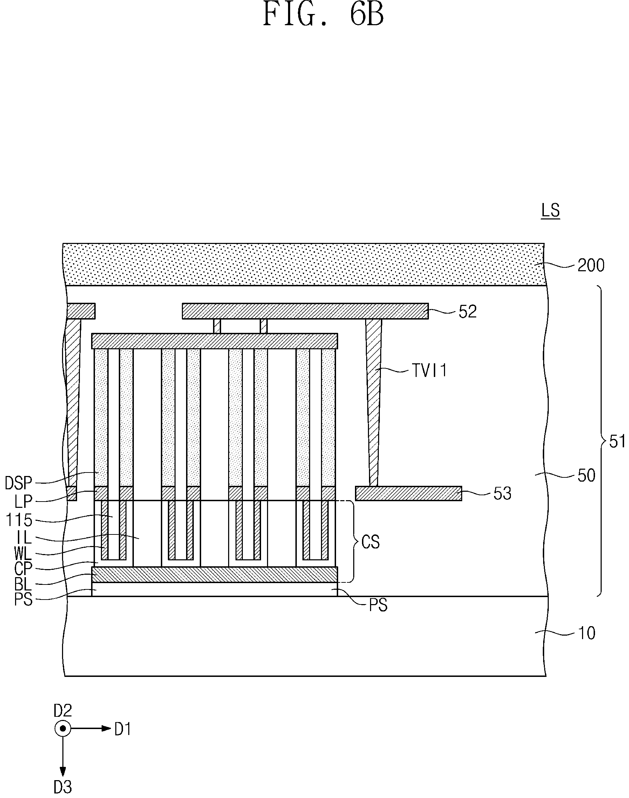

Referring to FIG. 6B, a second substrate 200 may be formed on the first lower interlayer dielectric layer 50. The second substrate 200 may be a silicon substrate, but the present inventive concepts are not limited thereto.

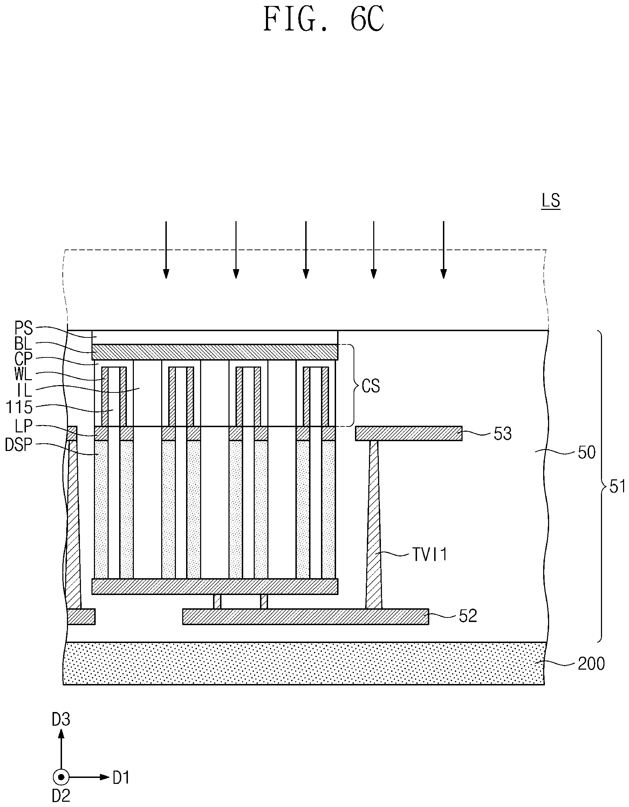

Referring to FIG. 6C, the first preliminary substrate 10 may be overturned (e.g. inverted) to at least partially expose a bottom surface of the first preliminary substrate 10. A silicon grinding process and/or a chemical mechanical polishing (CMP) process may be employed to remove the first preliminary substrate 10. The first preliminary substrate 10 may be removed to expose a top surface of the first lower interlayer dielectric layer 50.

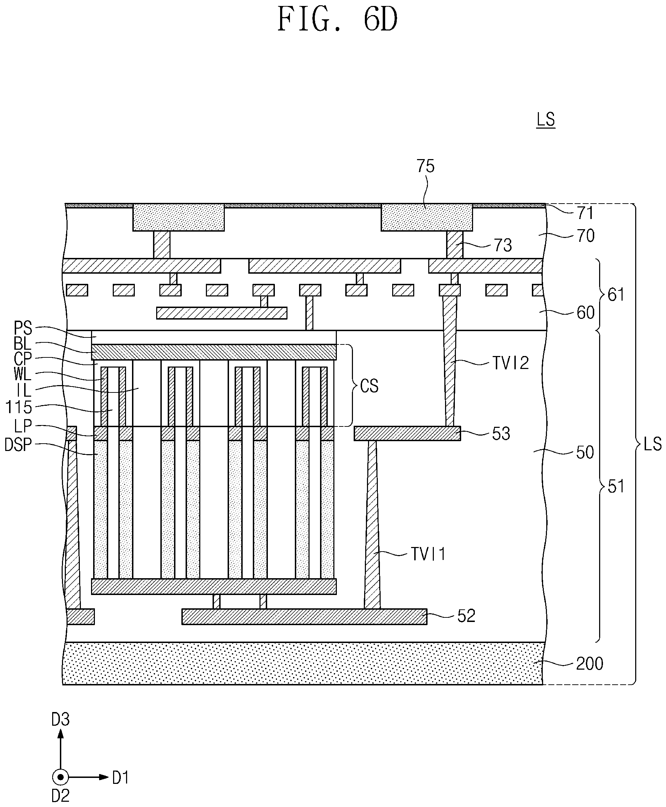

Referring to FIG. 6D, a second lower interlayer dielectric layer 60 may be formed on the first lower interlayer dielectric layer 50. A second through via TVI2 may be formed in the first lower interlayer dielectric layer 50. A lower wiring layer 61 may be formed in the second lower interlayer dielectric layer 60. The second through via TVI2 may electrically connect the lower wiring layer 61 to the second connection line 53.

A third lower interlayer dielectric layer 70 may be formed on the second lower interlayer dielectric layer 60. A second nitride pattern 71, a lower via 73, and a second bonding pad 75 may be formed in the third lower interlayer dielectric layer 70. The formation of the second nitride pattern 71 may include forming a nitride layer on a top surface of the third lower interlayer dielectric layer 70 and performing a chemical mechanical polishing (CMP) process to reduce a thickness of the nitride layer.

The formation of the second bonding pad 75 may include forming a mask pattern on the third lower interlayer dielectric layer 70, using the mask pattern as a mask to etch an upper portion of the third lower interlayer dielectric layer 70, and at least partially filling the etched upper portion of the third lower interlayer dielectric layer 70 with a metallic material. The second bonding pad 75 may be electrically connected through the lower via 73 to the lower wiring layer 61.

Referring again to FIG. 4, the upper structure US and the lower structure LS may be positioned to vertically (i.e., D3 direction) overlap and bond to each other. A rear surface USa of the upper structure US may be in contact with a front surface LSa of the lower structure LS. The first nitride pattern 81 of the upper structure US may be in contact with the second nitride pattern 71 of the lower structure LS. The first and second nitride patterns 81 and 71 may bond the upper structure US and the lower structure LS to each other. The first bonding pad 85 and the second bonding pad 75 may vertically (i.e., D3 direction) overlap to contact each other.

An annealing process may be performed on the upper structure US and the lower structure LS. The annealing process may direct bond the first bonding pad 85 and the second bonding pad 75 to each other. For example, the first bonding pad 85 and the second bonding pad 75 may form a single unitary or monolithic piece.

The first bonding pad 85 and the second bonding pad 75 may be formed of the same material (e.g., copper (Cu)). The first bonding pad 85 and the second bonding pad 75 may be combined due to an intermetallic hybrid bonding process caused by surface activation at an interface between the first bonding pad 85 and the second bonding pad 75 that are in contact with each other. When the first bonding pad 85 and the second bonding pad 75 are bonded to each other, no perfect incorporation may be achieved.

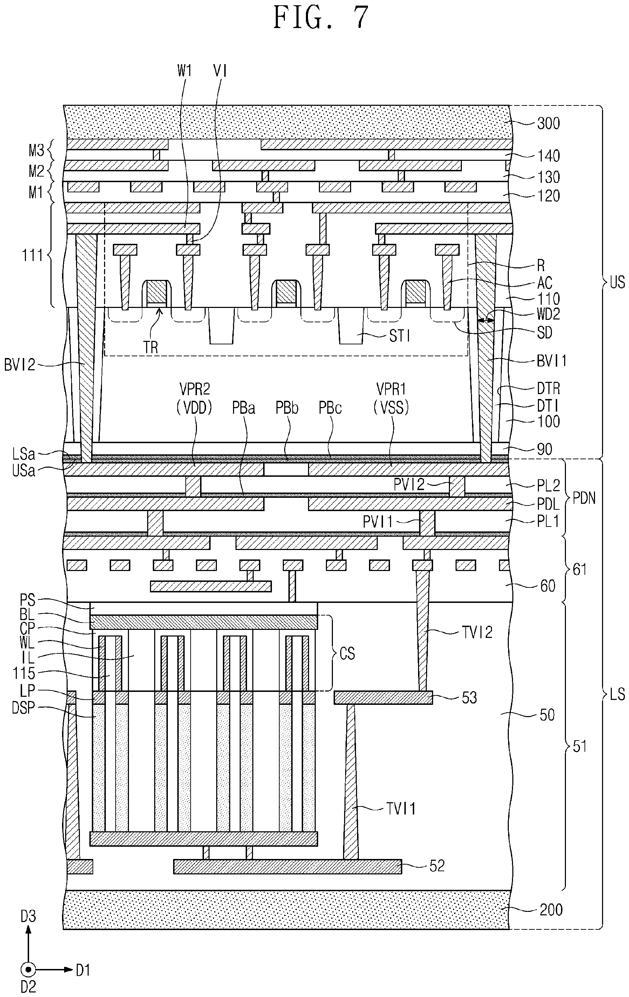

FIG. 7 is a cross-sectional view illustrating a semiconductor memory device according to some embodiments of the present inventive concepts. In the embodiment that follows, a detailed description of technical features repetitive to those discussed above with reference to FIG. 4 will be omitted, and a difference thereof will be discussed in detail.

Referring to FIG. 7, the upper structure US may be provided on the lower structure LS. The lower structure LS may include a power wiring layer PDN. The lower wiring layer PDN may be provided on the lower wiring layer 61. The power wiring layer PDN may include a first power wiring dielectric layer PL1 and a second power wiring dielectric layer PL2. The second power wiring dielectric layer PL2 may be provided on the first power wiring dielectric layer PL1. A first bonding pattern PBa may be provided between the first power wiring dielectric layer PL1 and the second power wiring dielectric layer PL2. The first bonding pattern PBa may include the same material as that of the first and second nitride patterns 71 and 81 discussed above. The first bonding pattern PBa may bond the first power wiring dielectric layer PL1 and the second power wiring dielectric layer PL2 to each other.

The power delivery network layer PDL may be provided in the first power wiring dielectric layer PL1. The first lower power via PVI1 may be provided beneath the power delivery network layer PDL. The power delivery network layer PDL may be electrically connected through the first lower power via PVI1 to the lower wiring layer 61.

The first and second lower power lines VPR1 and VPR2 may be provided in the second power wiring dielectric layer PL2. The second lower power via PVI2 may be provided beneath (i.e., D3 direction) the first and second lower power lines VPR1 and VPR2. The second lower power via PVI2 may connect the first lower power line VPR1 to the power delivery network layer PDL. The second lower power via PVI2 may connect the second lower power line VPR2 to the power delivery network layer PDL.

The lower substrate 80 may be omitted in the upper structure US. The first lower dielectric layer 90 of the upper structure US may be provided on the second power wiring dielectric layer PL2 of the upper structure US.

A second bonding pattern PBb and a third bonding pattern PBc may be interposed between the second lower wiring dielectric layer PL2 and the first lower dielectric layer 90. The second bonding pattern PBb may be provided on the front surface LSa of the lower structure LS. The third bonding pattern PBc may be provided on the rear surface USa of the upper structure US. The second and third bonding patterns PBb and PBc may be the same as the first and second nitride patterns 81 and 71 discussed above.

The first and second backside through vias BVI1 and BVI2 may be provided in the first substrate 100 of the upper structure US. The first and second backside through vias BVI1 and BVI2 may each have a second width WD2 in the first direction D1. The second width WD2 may increase with increasing distance in the vertical direction D3 from the rear surface USa of the upper structure US.

According to the present inventive concepts, the power wiring layer PDN may be disposed in the lower structure LS. Thus, there may be a reduction in resistance between wiring lines in the lower structure LS. In other embodiments, the bonding structure BD of FIG. 4 may be disposed on the boundary between the upper structure US and the lower structure LS.

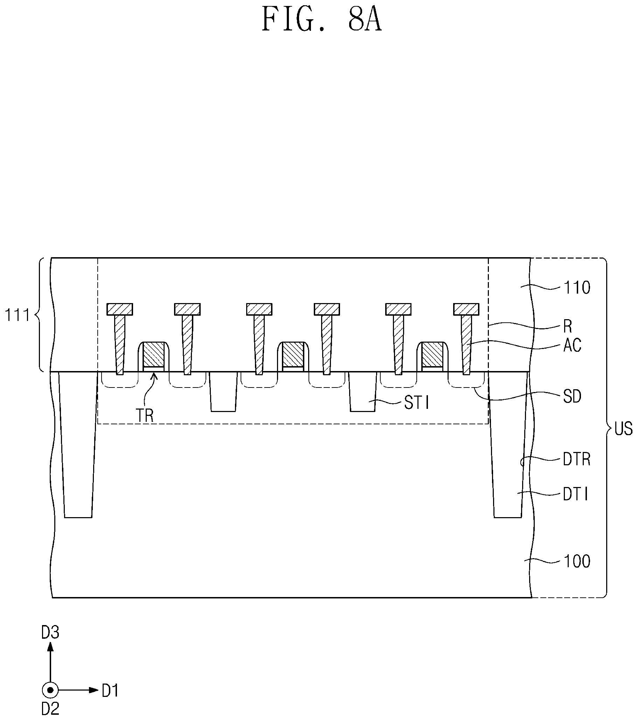

FIGS. 8A, 8B, 9A, 9B, 10, 11, and 12 are diagrams illustrating a method of fabricating a semiconductor memory device according to some embodiments of the present inventive concepts. In the embodiment that follows, a detailed description of technical features repetitive to those discussed with reference to FIGS. 5A to 6D will be omitted, and a difference thereof will be discussed in detail.

Referring to FIG. 8A, a peripheral region R may be formed on a first substrate 100. In other embodiments, a cell region may be formed on the first substrate 100. A deep device isolation pattern DTI, an isolation pattern STI, a transistor TR, and source/drain patterns SD may be formed on the first substrate 100. A first interlayer dielectric layer 110 may be formed on the first substrate 100. Active contacts AC may be formed in the first interlayer dielectric layer 110.

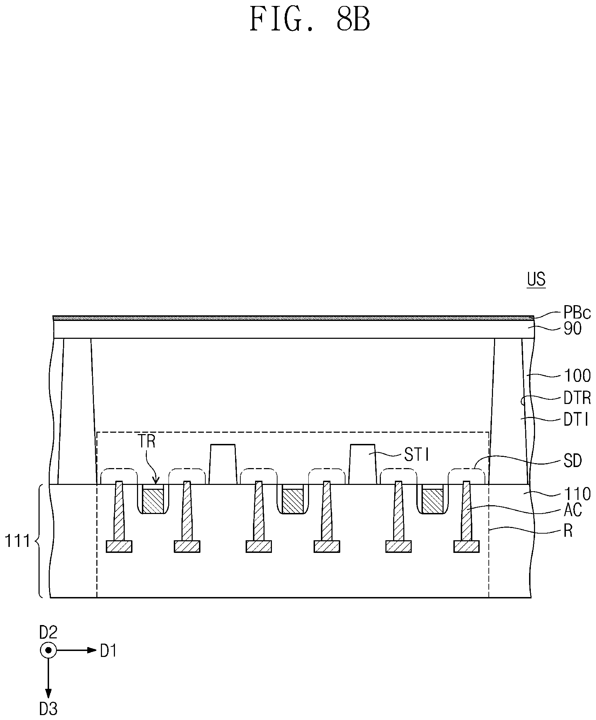

Referring to FIG. 8B, the first substrate 100 may be overturned (e.g. inverted) to at least partially expose a bottom surface of the first substrate 100. A silicon grinding process and/or a chemical mechanical polishing (CMP) process may be employed to reduce a thickness of the first substrate 100. The reduction in thickness of the first substrate 100 may at least partially expose a bottom surface of the deep device isolation pattern DTI.

A first lower dielectric layer 90 may be formed on the bottom surface of the first substrate 100. A first lower dielectric layer 90 may be formed on the first lower dielectric layer 90. The formation of the third bonding pattern PBc may include conformally forming a nitride layer on the first lower dielectric layer 90 and performing a chemical mechanical polishing (CMP) process to reduce a thickness of the nitride layer. Through the processes mentioned above, an upper structure US may be formed.

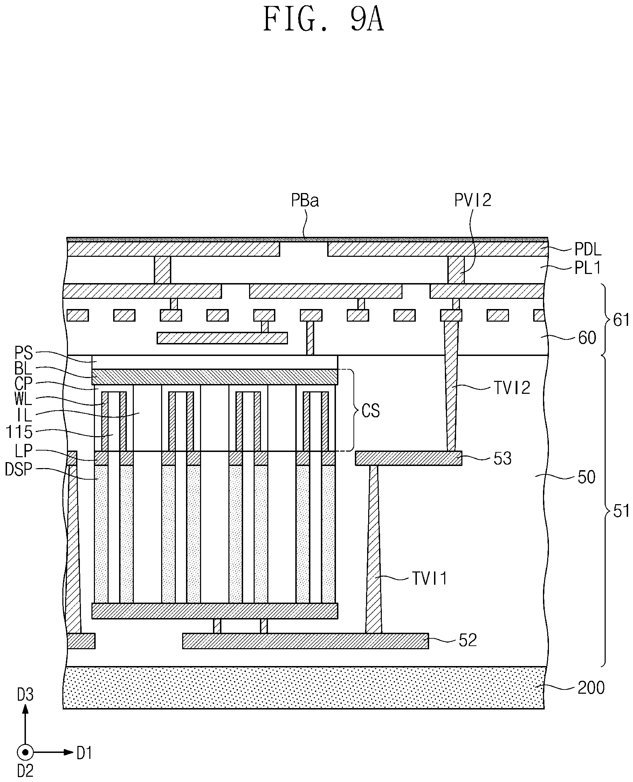

Referring to FIG. 9A, a first lower interlayer dielectric layer 50 may be formed on a second substrate 200. A memory cell region 51, connection lines 52 and 53, and through vias TVI1 and TVI2 may be formed in the first lower interlayer dielectric layer 50. A second lower interlayer dielectric layer 60 may be formed on the first lower interlayer dielectric layer 50. A lower wiring layer 61 may be formed in the second lower interlayer dielectric layer 60.

A first power wiring dielectric layer PL1 may be formed on the second lower interlayer dielectric layer 60. A second lower power via PVI2 and a power delivery network layer PDL may be sequentially formed in the first power wiring dielectric layer PL1. A first bonding pattern PBa may be formed on the first power wiring dielectric layer PL1. The formation of the first bonding pattern PBa may include conformally forming a nitride layer on the first lower dielectric layer 90 and performing a chemical mechanical polishing (CMP) process to reduce a thickness of the nitride layer.

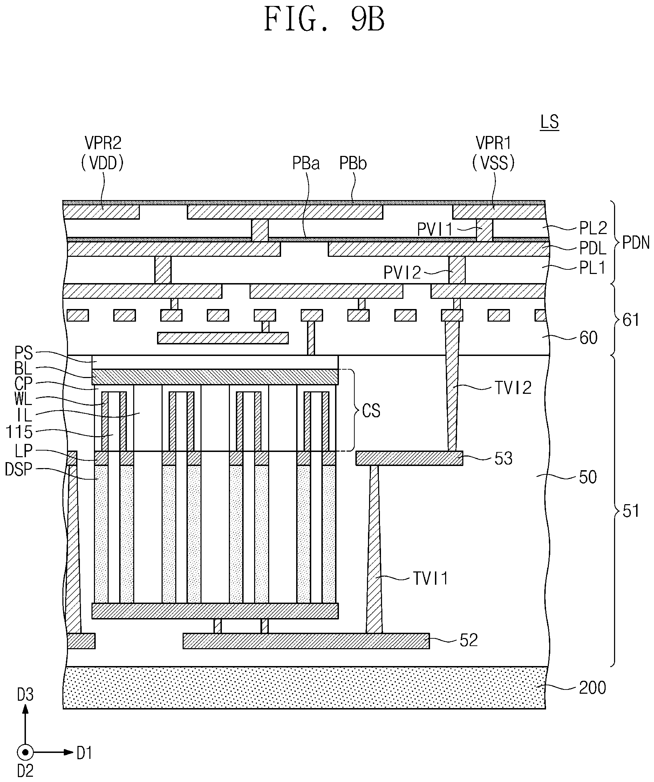

Referring to FIG. 9B, a second power wiring dielectric layer PL2 may be formed on the first power wiring dielectric layer PL1. The first power wiring dielectric layer PL1 and the second power wiring dielectric layer PL2 may be combined through the first bonding pattern PBa. A first lower power via PVI1 and first and second lower power lines VPR1 and VPR2 may be sequentially formed in the second power wiring dielectric layer PL2. The first lower power via PVI1 may penetrate the first bonding pattern PBa.

A second bonding pattern PBb may be formed on the second power wiring dielectric layer PL2. The formation of the second bonding pattern PBb may include conformally forming a nitride layer on the first lower dielectric layer 90 and performing a chemical mechanical polishing (CMP) process to reduce a thickness of the nitride layer. Through the processes mentioned above, a lower structure LS may be formed.

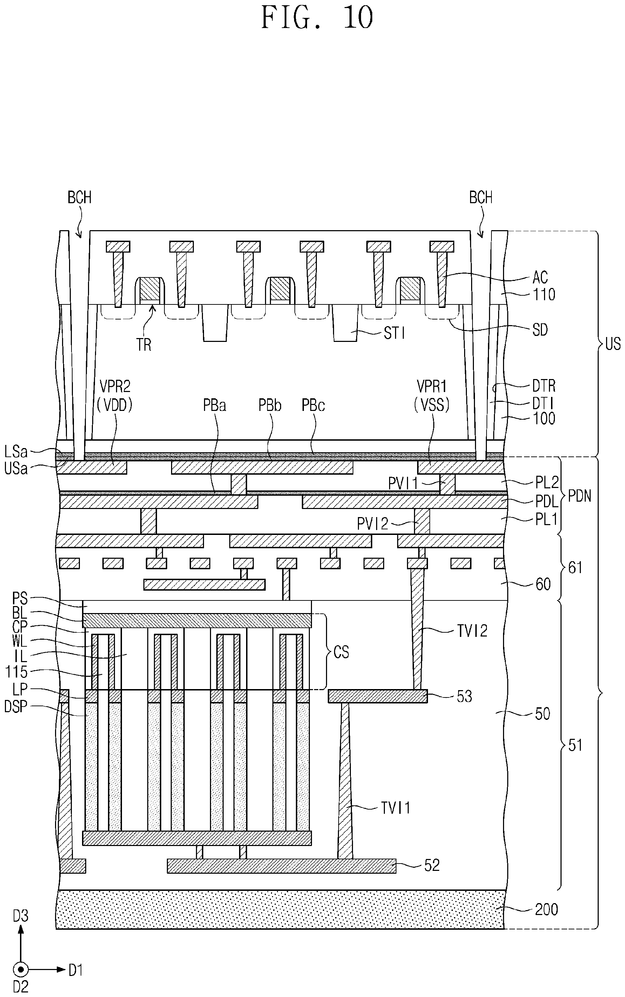

Referring to FIG. 10, the upper structure US and the lower structure LS may be bonded to each other. A rear surface USa of the upper structure US may be in contact with a front surface LSa of the lower structure LS. The upper structure US and the lower structure LS may be combined through the second bonding pattern PBb and the third bonding pattern PBc.

A backside contact hole BCH may be formed in the upper structure US. The backside contact hole BCH may penetrate or extend through the first interlayer dielectric layer 110, the first substrate 100, and the first lower dielectric layer 90 to at least partially expose the first and second lower power lines VPR1 and VPR2 of the lower structure LS. The backside contact hole BCH may penetrate or extend through the second and third bonding patterns PBb and PBc. A width in the first direction D1 of the backside contact hole BCH may decrease with increasing distance in the vertical direction D3 from a top surface of the first interlayer dielectric layer 110.

The formation of the backside contact hole BCH may include, for example, forming a mask pattern on the first interlayer dielectric layer 110 and using the mask pattern as a mask to etch the first interlayer dielectric layer 110, the first substrate 100, and the first lower dielectric layer 90.

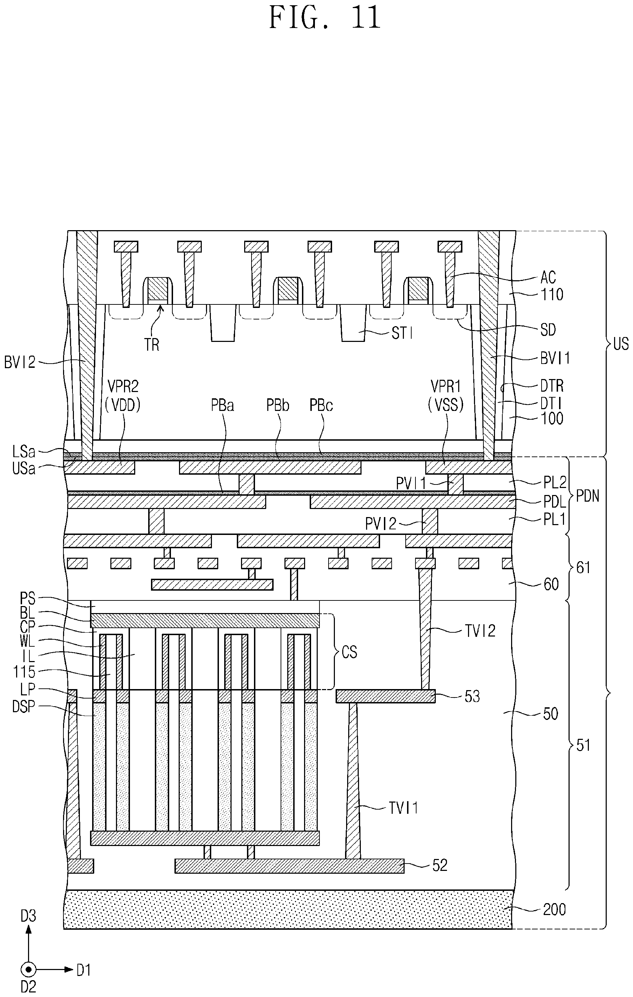

Referring to FIG. 11, the backside contact hole BCH may be at least partially filled with a metallic material to form a backside through via BVI. For example, the backside through via BVI may include at least one metallic material selected from aluminum, copper, tungsten, molybdenum, ruthenium, and cobalt.

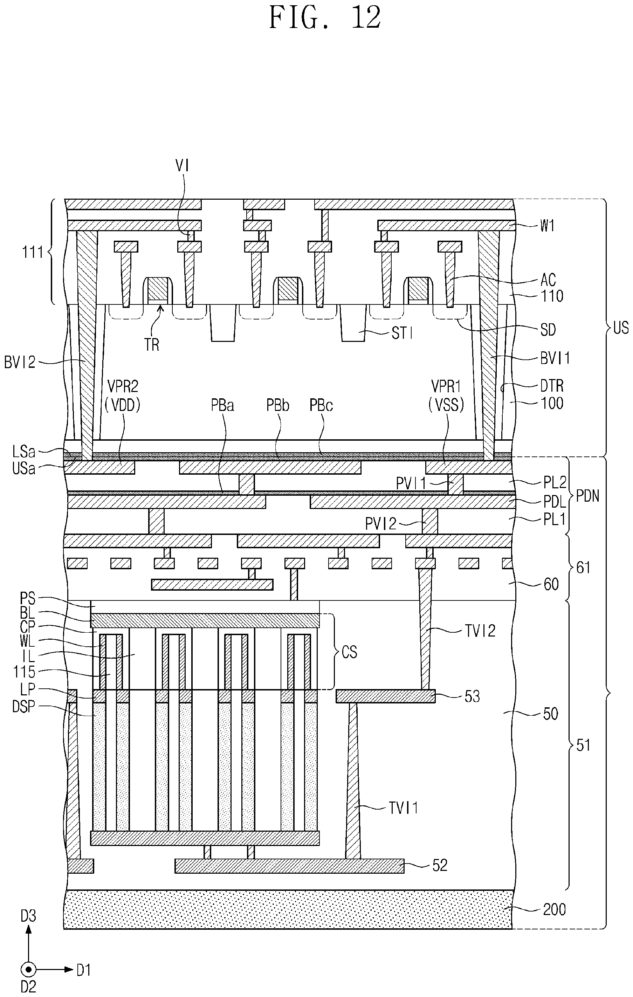

Referring to FIG. 12, an upper wiring line W1 and upper vias VI may be formed in the first interlayer dielectric layer 110. The transistor TR and the source/drain patterns SD may be electrically connected through the active contact AC to the wiring line W1. The backside through via BVI may vertically and electrically connect the upper wiring line W1 to the first and second lower power lines VPR1 and VPR2. The active contact AC may be electrically connected through the upper wiring line W1 to the backside through via BVI.

Referring to FIG. 7, second, third, and fourth interlayer dielectric layers 120, 130, and 140 may be formed on the first interlayer dielectric layer 110. A first metal layer M1 may be formed in the second interlayer dielectric layer 120. A second metal layer M2 may be formed in the third interlayer dielectric layer 130. A third metal layer M3 may be formed in the fourth interlayer dielectric layer 140. A first support substrate 300 may be formed on the fourth interlayer dielectric layer 140. In other embodiments, the first support substrate 300 may be omitted.

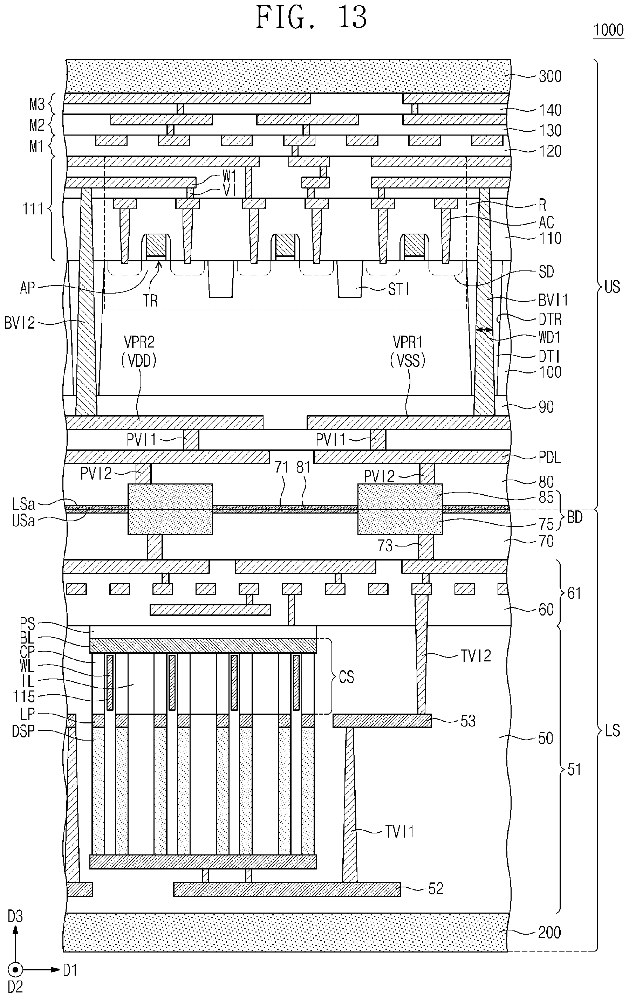

FIG. 13 is a cross-sectional view illustrating a semiconductor memory device according to some embodiments of the present inventive concepts. In the embodiment that follows, a detailed description of technical features repetitive to those discussed above with reference to FIG. 4 will be omitted, and a difference thereof will be discussed in detail.

Referring to FIG. 13, the channel pattern CP may be provided on the bit line BL. The channel pattern CP may extend in the vertical direction D3 from a top surface of the bit line BL. The word line WL may be provided between a pair of channel patterns CP that are adjacent to each other. The word lines WL may be spaced apart from each other in the second direction D2. The mold dielectric patterns IL may be provided between a pair of channel patterns CP that are adjacent to each other. The mold dielectric patterns IL may be spaced apart from each other in the second direction D2. The word lines WL and the mold dielectric patterns IL may be alternately provided between the channel patterns CP. The bit line BL may extend in the first direction D1, and the word line WL may extend in the second direction D2.

In a semiconductor memory device according to some embodiments of the present inventive concepts, a lower structure and an upper structure may be combined through a bonding structure. The upper structure may include a lower power line buried in a lower portion of a substrate, and the lower power line may be electrically connected to the bonding structure. The upper structure may be electrically connected through the bonding structure to the lower structure.

The bonding structure may include a first bonding pad buried in a lower portion of the upper structure and a second bonding pad buried in an upper portion of the lower structure. The first bonding pad and the second bonding pad may include the same material and may constitute a single unitary or monolithic piece. Thus, the lower structure and the upper structure may be connected to each other, and at the same time, the lower power line of the upper structure and the bonding structure may be electrically connected, which may result in an increase in the degree of wiring freedom. In conclusion, the semiconductor memory device may increase in desired electrical properties.

Embodiments are set out in the following Clauses:
Clause 1. A semiconductor memory device, comprising:
   a lower structure; and
   an upper structure on the lower structure,
   wherein the upper structure includes:
      a first substrate;
      an upper wiring line on the first substrate;
      a lower power line in a lower portion of the first substrate; and
      a first bonding pad between the lower power line and the lower structure,
   wherein the lower structure includes:
      a second substrate that includes a cell region; and
      a second bonding pad on the cell region,
   wherein the first bonding pad is exposed through a rear surface of the upper structure,
   wherein the second bonding pad is exposed through a front surface of the lower structure,
   wherein the front surface of the lower structure is in contact with the rear surface of the upper structure, and
   wherein the first bonding pad and the second bonding pad directly contact each other.
Clause 2. The device of Clause 1, further comprising a backside through via that extends through the first substrate and electrically connects the upper wiring line to the lower power line.
Clause 3. The device of Clause 1 or Clause 2, wherein
   the first bonding pad is electrically connected to the lower power line, and
   the second bonding pad is electrically connected to a lower wiring line on the cell region.
Clause 4. The device of any preceding Clause, wherein the cell region of the lower structure includes:
   a data storage pattern on the second substrate;
   a landing pad on the data storage pattern;
   a channel pattern on the landing pad, wherein the landing pad electrically connects the channel pattern and the data storage pattern to each other;
   a word line adjacent to the channel pattern; and
   a bit line on the channel pattern,
   wherein the bit line extends in a first direction, and
   wherein the word line extends in a second direction that intersects the first direction.
Clause 5. The device of any preceding Clause, further comprising a power delivery network layer between the lower power line and the lower structure,
   wherein the power delivery network layer is configured to apply a voltage to the lower power line.
Clause 6. A semiconductor memory device, comprising:
   a lower structure;
   an upper structure on the lower structure; and
   a bonding structure between the lower structure and the upper structure,
   wherein the upper structure includes:
      a first substrate;
      an upper wiring line on the first substrate;
      a lower power line in a lower portion of the first substrate; and
      a backside through via that extends through the first substrate and connects the upper wiring line to the lower power line,
   wherein the lower structure includes:
      a second substrate that includes a cell region; and
      a lower wiring layer on the cell region,
   wherein the bonding structure includes:
      a first part in a lower portion of the upper structure; and
      a second part in an upper portion of the lower structure,
   wherein the bonding structure electrically connects the lower power line and the lower wiring layer to each other.
Clause 7. The device of Clause 6, further comprising:
   a transistor on the first substrate;
   a plurality of source/drain patterns on opposite sides of the transistor; and
   an active contact electrically connected to each of the source/drain patterns, wherein the active contact is electrically connected to the backside through via.
Clause 8. The device of Clause 6 or Clause 7, wherein at least one selected from the upper structure and the lower structure further includes:
   a data storage pattern on the second substrate;
   a landing pad on the data storage pattern;
   a channel pattern on the landing pad, wherein the landing pad electrically connects the channel pattern and the data storage pattern to each other;
   a word line adjacent to the channel pattern; and
   a bit line on the channel pattern,
   wherein the bit line extends in a first direction, and
   wherein the word line extends in a second direction that intersects the first direction.
Clause 9. The device of any of Clauses 6-8, further comprising a power delivery network layer between the lower power line and the lower structure,
   wherein the power delivery network layer is configured to apply a voltage to the lower power line.
Clause 10. The device of any of Clauses 6-9, further comprising a deep device isolation pattern that extends through the first substrate.

Although the present invention has been described in connection with the embodiments of the present inventive concepts illustrated in the accompanying drawings, it will be understood to those skilled in the art that various changes and modifications may be made without departing from the essential features of the present inventive concepts. It therefore will be understood that the embodiments described above are just illustrative but not limitative in all aspects.

## Claims

1. A semiconductor memory device, comprising:
a lower structure; and
an upper structure on the lower structure,
wherein the upper structure includes:
a first substrate;
an upper wiring line on the first substrate;
a lower power line in a lower portion of the first substrate; and
a first bonding pad between the lower power line and the lower structure,
wherein the lower power line and the first bonding pad are electrically connected to each other, and
wherein the upper structure is electrically connected through the first bonding pad to the lower structure.

2. The device of claim 1, wherein the lower structure includes a second bonding pad, wherein the first bonding pad and the second bonding pad directly contact each other.

3. The device of claim 1 or claim 2, wherein the lower structure further includes:
a second substrate;
a data storage pattern on the second substrate;
a landing pad on the data storage pattern;
a channel pattern on the landing pad, wherein the landing pad electrically connects the channel pattern and the data storage pattern to each other;
a word line adjacent to the channel pattern; and
a bit line on the channel pattern,
wherein the bit line extends in a first direction, and
wherein the word line extends in a second direction that intersects the first direction.

4. The device of claim 3, when dependent on claim 2, further comprising a lower wiring line between the bit line and the second bonding pad,
wherein the lower wiring line is electrically connected to the second bonding pad.

5. The device of any preceding claim, further comprising a deep device isolation pattern that extends through the first substrate.

6. The device of claim 5, further comprising a backside through via that extends through the deep device isolation pattern,
wherein the backside through via electrically connects the upper wiring line and the lower power line to each other.

7. The device of claim 6, wherein a width of the backside through via decreases with distance in a direction perpendicular to a top surface of the lower power line extending away from the lower structure.

8. The device of claim 6 or claim 7, further comprising:
a transistor on the first substrate;
a plurality of source/drain patterns on opposite sides of the transistor; and
an active contact electrically connected to each of the source/drain patterns,
wherein each active contact is electrically connected to a corresponding backside through via.

9. The device of any preceding claim, further comprising a power delivery network layer between the lower power line and the lower structure,
wherein the power delivery network layer is configured to apply a voltage to the lower power line.

10. The device of any preceding claim, further comprising a nitride pattern between the upper structure and the lower structure.

11. The semiconductor memory device of claim 1, wherein:
the lower structure includes:
a second substrate that includes a cell region; and
a second bonding pad on the cell region,
the first bonding pad is exposed through a rear surface of the upper structure,
the second bonding pad is exposed through a front surface of the lower structure,
the front surface of the lower structure is in contact with the rear surface of the upper structure, and
the first bonding pad and the second bonding pad directly contact each other.

12. The device of claim 11, further comprising a backside through via that extends through the first substrate and electrically connects the upper wiring line to the lower power line.

13. The device of claim 11 or claim 12, wherein
the second bonding pad is electrically connected to a lower wiring line on the cell region.

14. The device of any of claims 11-13, wherein the cell region of the lower structure includes:
a data storage pattern on the second substrate;
a landing pad on the data storage pattern;
a channel pattern on the landing pad, wherein the landing pad electrically connects the channel pattern and the data storage pattern to each other;
a word line adjacent to the channel pattern; and
a bit line on the channel pattern,
wherein the bit line extends in a first direction, and
wherein the word line extends in a second direction that intersects the first direction.

15. The device of any of claims 11-14, further comprising a power delivery network layer between the lower power line and the lower structure,
wherein the power delivery network layer is configured to apply a voltage to the lower power line.
